# EUROPEAN PATENT SPECIFICATION

(11) **EP 3 164 896 B1**
(45) Date of publication and mention of the grant of the patent: **06.03.2019**
(21) Application number: 15747503.9
(22) Date of filing: 01.07.2015
(51) Int. Cl.: H01L 35/30, H01L 35/32, E04C 2/52

(54) **THERMOELECTRIC MODULE**
THERMOELEKTRISCHES MODUL
MODULE THERMOÉLECTRIQUE

(30) Priority: 02.07.2014 GB 201411817
(43) Date of publication of application: 10.05.2017
(73) Proprietor: Elsarrag, Esam, Doha, Qatar (QA); Al-Horr, Yousef, Doha, Qatar (QA)
(72) Inventor: Elsarrag, Esam, Doha, Qatar (QA); Al-Horr, Yousef, Doha, Qatar (QA)
(74) Representative: Gaunt, Thomas Derrick
(86) International application number: PCT/GB2015/051923
(87) International publication number: WO 2016/001664

(56) References cited:
- EP-A2- 2 262 019
- DE-A1- 19 946 806
- GB-A- 2 119 170
- US-A1- 2011 023 930

## Description

The present invention relates to a thermoelectric module, and in particular a thermoelectric module for attachment to a wall of a building.

In countries that have a particularly hot or cold climate, a building such as a house or an office may be built having a wall structure comprising internal and external walls separated by an air gap or cavity. This air gap reduces the overall heat transfer between the inside of the building and the outside of the building, due to the low thermal conductivity of air (around 0.0271 W/m.K compared to around 1.7 W/m.K for concrete). Accordingly, in a hot climate, where the sun delivers solar energy to the external walls of the building, the amount of heat or thermal energy transferred from the hot outside of the building to the cold inside of the building is reduced. Similarly, in a cold climate, the amount of heat or thermal energy transferred from the hot inside of the building to the cold outside of the building is reduced.

In order to further reduce this heat transfer to the inside of a building in a hot climate, it is possible to cool the outside wall by establishing an air flow in the cavity within the wall structure by use of a fan. However, such a fan requires an electrical power supply to operate, and consequently increases the building's complexity in that a connection to the mains electrical grid is then required.

To address this issue, it had been proposed that solar panels or thermoelectric modules might potentially offer a local power supply for driving air circulation within wall cavities. Indeed, even without the need to power a local fan, such energy recovery technology integrated into a wall structure could offer improved efficiency gains by reducing heat transferred through the wall. However, there are a number of issues preventing the adoption of these. Firstly, the use of solar panels requires substantive modification to the wall exterior, which therefore increases expense and limits where such panels may be used. Thermoelectric modules potentially offer more straightforward integration into a wall structure. However, conventional thermoelectric modules are not particularly effective at generating electricity in this application. The present inventors have recognised that the reason for this is that conventional thermoelectric modules are conventionally used for very high temperature applications, such as in ovens or commercial furnaces. Accordingly, until now, thermoelectric modules have been designed to operate with a ΔT of over 200°C. As such, when attempts have been made to use this technology within a wall structure, where the ΔT is typically in the region of 20°C-30°C, the power generated is comparatively low.

Furthermore, the present inventors have also identified that since conventional thermoelectric modules are provided as small and rigid components, they are difficult to fit on to a wall structure. As such, further efficiency is lost by establishing poor heat transfer with a wall, not least because the surface of the wall structure often covers a much larger area and may be uneven.

JP 2006 032850 discloses a thermoelectric conversion module having p and n type semiconductor elements fitted to through-holes on a supporting board. The elements are connected by electrodes, having insulating layers stacked on the outer faces.

GB 2 119 170 discloses a thermoelectric device comprising thermoelectric elements disposed between sets of spaced apart copper plate segments. A potting compound fills the void between the thermoelectric elements and the plate segments.

US 2011/023930 discloses a method of producing a thermoelectric component having at least one pair of legs welded to an electrically conductive material.

EP 2 262 019 discloses a thermoelectric module having multiple thermal-electrical active materials arranged between two surfaces for producing an electrical voltage. Two sets of multiple electrical conductors connect the materials via the contact surfaces.

DE 199 46 806 describes the use of thermoelectric modules as power modules in various situations for utilising environmental temperature differences to generate electricity. In one embodiment, the thermoelectric module is installed in a wall panel for a building.

The present invention seeks to overcome or mitigate the aforementioned problems associated with the prior art.

According to an aspect of the present invention, there is provided a thermoelectric module for use in a wall of a building comprising: a thermoelectric generator having a heat absorbing side and a heat dissipating side and comprising a plurality of thermoelectric legs extending therebetween; and a support member for supporting the thermoelectric legs, provided between the heat absorbing side and heat dissipating side, wherein the thermoelectric legs pass through channels provided in the support member and the height of the thermoelectric legs is greater than the height of the support member so that ends of the thermoelectric legs protrude from the support member; and characterised in that the thermoelectric module further comprises sealant for sealing the thermoelectric legs at the gap between the support member and the conductive interconnects.

With this arrangement, the provision of the support member in the middle of the module between the heat absorbing side and heat dissipating side allows these sides of the thermoelectric generator to be positioned in a more superficial location and thereby absorb and dissipate heat more effectively, whilst at the same time allowing the support member to support the thermoelectric legs and protect them from damage. Furthermore, the legs are housed securely within the channels in order to insulate them and prevent damage. This contrasts with conventional thermoelectric modules where the generator is embedded within the interior of a rigid support encapsulant, which surrounds its heat absorbing and heat dissipating sides. This encapsulant thereby presents a barrier to heat transfer to the thermoelectric legs.

In this connection, the central support provided with the present invention allows the heat absorbing side to be positioned closer to, or even in direct contact with, the wall of a building, which is acting as a heat source. This therefore allows a greater heat transfer to it.

Similarly, the heat dissipating side is also more exposed, thereby improving its heat dissipation.

As such, the temperature differential (ΔT) between the heat absorbing and heat dissipating sides is maximised.

The present invention is therefore able to generate electricity more effectively at the ΔT typically found within a wall structure of a building.

Preferably, the heat absorbing side and the heat dissipating side comprise conductive interconnects provided alternately on opposing ends of the thermoelectric legs to connect the plurality of thermoelectric legs in series.

Preferably, each conductive interconnect on the heat dissipating side comprises a shaped section that projects outward from a plane defined by the conductive interconnects on the heat dissipating side. Preferably, the shaped section is concertina shaped or corrugated. In this way, the increased surface area of the shaped section provides for a greater heat transfer between the heat dissipating conductive interconnects and passing airflow, allowing for heat to quickly dissipate. At the same time, the shaped section provides the thermoelectric module with greater flexibility as the folds in the section between the legs allows for relative movement between the connected legs. This in turn allows the module to maintain closer contact with uneven surfaces, thereby increasing the heat transferred to the thermoelectric module.

Preferably, the support member is partially flexible for maintaining contact between the heat absorbing side and a surface of the wall of a building. In this way, the thermoelectric module is able to bend to conform to uneven wall surfaces. This provides improved contact for increasing heat transfer.

Preferably, the conductive interconnects provided on the heat absorbing side are formed as flat strips. In this way, the conductive interconnects present a flat plane, increasing their surface area in contact with the heated wall surface.

Preferably, the edges of each of the plurality of conductive interconnects extend beyond the ends of the respective thermoelectric legs to which it is connected. In this way, the interconnects provide their connected thermoelectric leg with an increased heat transfer surface area.

Preferably, the plurality of conductive interconnects provided on the heat absorbing side and/or the heat dissipating side are exposed on the outside of the module. In this way, the conductive interconnects are able to directly absorb or dissipate heat to an adjacent heat source or air flow with no barrier to impede this heat flow. The heat absorbing side is therefore able to absorb heat from the wall surface faster, increasing the temperature of this side of the thermoelectric module, whilst at the same time, the heat dissipating side is able to dissipate heat to the environment faster.

Preferably, the thermoelectric module further comprises a mounting for securing the heat absorbing side to a surface of the wall of a building. In this way, the mounting maintains contact with the wall surface to maximise the rate of heat transfer.

According to another aspect of the present invention, there is provided a wall panel for a building comprising a thermoelectric module according to any of the above statements.

Illustrative embodiments of the invention will now be described, with reference to the accompanying drawings in which:
Figure 1 shows a plan view of a thermoelectric module according to an embodiment of the invention;
Figure 2 shows side cross sectional view of part of the thermoelectric module shown in Figure 1; and
Figure 3 shows a side cross sectional view of a section of a wall structure of a building incorporating a thermoelectric module according to an embodiment of the invention.

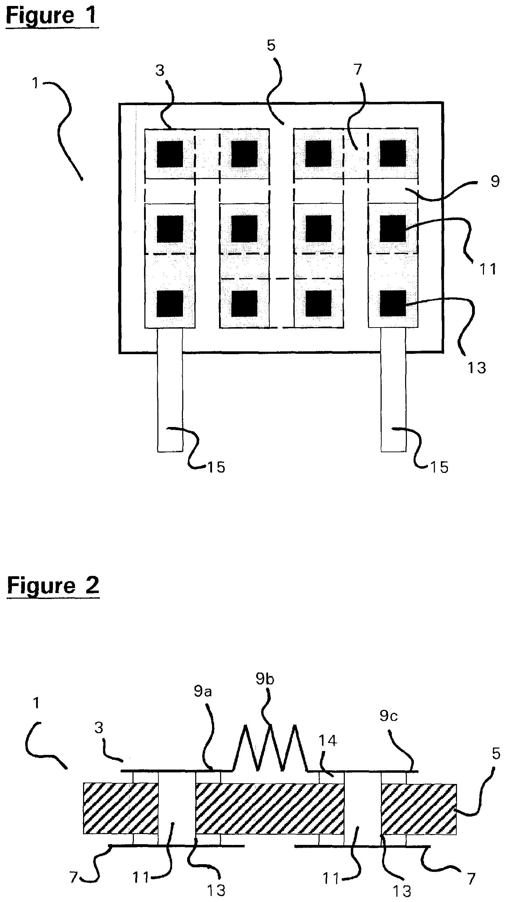

Figure 1 shows a plan view of a thermoelectric module 1 according to an embodiment of the invention. The thermoelectric module 1 has a generally planar configuration and comprises a thermoelectric generator 3 and a support member 5. The thermoelectric generator 3 comprises an array of thermoelectric legs 11 with a plurality of conductive interconnects 7, 9 provided alternately on opposing ends of the thermoelectric legs, such that the legs are connected electrically in series. In this way, the conductive interconnects define heat absorbing and heat dissipating sides of the module. Figure 1 shows a view of the heat absorbing side of the thermoelectric generator 3 and therefore the heat absorbing side conductive interconnects 7 can be seen. The heat dissipating side conductive interconnects 9 are on the reverse and are shown as dashed lines.

The thermoelectric legs 11 of the thermoelectric generator 3 are housed within channels 13 passing through the support member 5. Electrical leads 15 are provided for delivering electricity generated by the thermoelectric module 1.

Figure 2 shows a cross section of part of the thermoelectric module 1 shown in Figure 1.

The thermoelectric legs 11 pass through channels 13 provided in the support member 5. The height of the legs 11 is greater than the height of the support member 5 such that end faces of the legs 11 extend beyond and protrude from the support member 5. The conductive interconnects connect the ends of the legs through solder formed from metal or a metallic material. Sealant 14 is used to fill the gap between the support member 5 and the conductive interconnects 7, 9.

The thermoelectric legs 11 each have a high temperature side and a low temperature side. In Figure 2 the heat absorbing side is provided with conductive interconnects 7 connected to the high temperature side of the legs 11, and the heat dissipating side is provided with conductive interconnects 9 connected to the low temperature side of the legs 11.

The heat absorbing interconnects 7 comprise flat strips and are formed from metal or a metallic material, presenting a flat plane for contact with the wall of a building, which is acting as a heat source.

The heat dissipating interconnect 9 shown in Figure 2 comprises three sections. The outer sections comprising flat portions that present a flat plane 9a, 9c for connection to the end of the legs 11. Between these flattened sections is a central shaped section 9b, which forms an integral heat sink by providing an increased surface area. Specifically, the shaped section projects outward from the normal plane defined the two outer portions 9a, 9c forming a concertina shape. As such, the shaped section adopts a zig zag shape in profile.

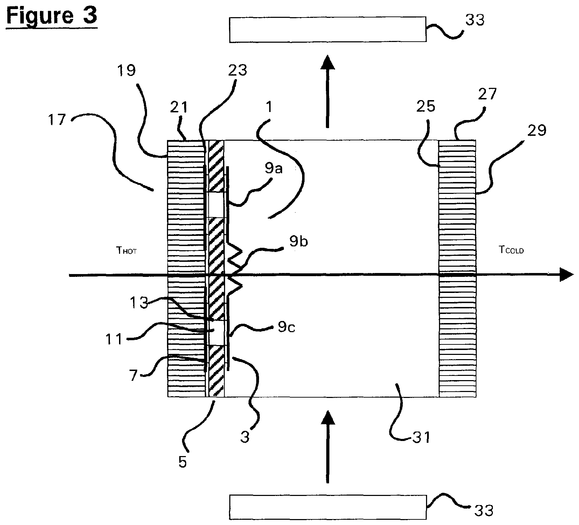

Figure 3 shows a side cross sectional view of a section of a wall structure 17 of a building incorporating the thermoelectric module 1 shown in Figure 2. In this embodiment, the wall structure 17 is intended for use in a hot climate where the temperature outside of the building (T_{HOT}) is greater than the temperature inside of the building (T_{COLD}).

The wall structure 17 comprises an external layer 21 having an interior facing side 23 and an exterior facing side 19, and an internal layer 27 also having an interior facing side 29 and an exterior facing side 25. The two layers 21, 27 are separated by a cavity 31, through which air can flow. In Figure 3 the air flow is driven due to the action of fans 33.

As can be seen, the thermoelectric module 1 is attached to the interior facing side 23 of the external layer 21 so that the heat absorbing conductive interconnects 7 are in direct contact with the interior facing side 23. The heat dissipating conductive interconnects 9 are therefore exposed within the cavity 31, with the concertina shape of the central section 9b exposed to the airflow within the cavity. The concertina shape also provides the thermoelectric module 1 with increased flexibility across its length such that it is able to maintain contact with the interior facing side 23, even if the wall structure's surface is uneven.

In use, warm outside air and radiation from the sun heats the exterior facing side 19 of the wall's external layer 21, increasing its temperature. The heat absorbed conducts through the external layer 21 where it is absorbed by the heat absorbing conductive interconnects 7 of the thermoelectric module 1. This increases their temperature, which then conducts through the thermoelectric legs 11 to the heat dissipating interconnects 9 on the heat dissipating side of the module 1. These are exposed within the cavity 31 and act as a heat sink. The lower temperature within the cavity 31 causes heat to be rejected from the heat dissipating interconnects 9, thus cooling them and reducing the temperature of the connected low temperature side of the thermoelectric legs 11.

The temperature difference across the thermoelectric legs 11 causes electricity to be generated, which is output via leads 15 and which can then be used to power fans 33. This can, in turn, further cool the heat dissipating side of the thermoelectric module 1 to generate further electricity. Accordingly, no external source of electricity is required and the building's overall thermal management is improved.

It will be understood that the embodiment illustrated above shows applications of the invention only for the purposes of illustration. In practice the invention may be applied to many different configurations, the detailed embodiments being straightforward for those skilled in the art to implement.

For example, when the temperature of the inside of the building having the wall structure is higher than the temperature of the outside of the building, the thermoelectric module 1 may be attached to the outside 25 of the internal layer 27 by the heat absorbing side, such that the heat dissipating side is exposed within the cavity 31. This would allow the thermoelectric module to generate electricity using the heat of the inside of the building.

In addition, the air flow within the cavity 31 may not be caused by a fan 33. Instead, it may flow due to natural convention. Alternatively, the air within the cavity 31 may not flow and instead act as a static heat sink. Equally, electricity generated by the thermoelectric module need not be used to drive fans, but instead could be stored or used for other purposes, such as to power lighting.

## Claims

1. A thermoelectric module (1) for use in a wall of a building comprising:
a thermoelectric generator (3) having a heat absorbing side and a heat dissipating side and comprising a plurality of thermoelectric legs (11) extending therebetween; and
a support member (5) for supporting the thermoelectric legs (11), provided between the heat absorbing side and heat dissipating side,
wherein the thermoelectric legs (11) pass through channels (13) provided in the support member (5) and the height of the thermoelectric legs (11) is greater than the height of the support member (5) so that ends of the thermoelectric legs (11) protrude from the support member (5); and
**characterised in that** the thermoelectric module (1) further comprises sealant (14) for sealing the thermoelectric legs (11) at the gap between the support member (5) and the conductive interconnects (7,9).

2. A thermoelectric module (1) according to claim 1 wherein the heat absorbing side and the heat dissipating side comprise the conductive interconnects (7,9) provided alternately on opposing ends of the thermoelectric legs (11) to connect the plurality of thermoelectric legs (11) in series.

3. A thermoelectric module (1) according to claim 2 wherein each conductive interconnect (9) on the heat dissipating side comprises a shaped section (9b) that projects outward from a plane defined by the conductive interconnects (9) on the heat dissipating side.

4. A thermoelectric module (1) according to any preceding claim wherein the support member (5) is partially flexible for maintaining contact between the heat absorbing side and a surface of the wall (23) of a building.

5. A thermoelectric module (1) according to any one of claims 2 to 4 wherein the conductive interconnects (7) provided on the heat absorbing side are formed as flat strips.

6. A thermoelectric module (1) according to any one of claims 2 to 5 wherein the edges of each of the plurality of conductive interconnects (7,9) extend beyond the ends of the respective thermoelectric legs (11) to which it is connected.

7. A thermoelectric module (1) according to any one of claims 2 to 6 wherein the plurality of conductive interconnects (7,9) provided on the heat absorbing side and/or the heat dissipating side are exposed on the outside of the module (1).

8. A thermoelectric module (1) according to any one of claims 3 to 7 wherein the shaped section is concertina shaped or corrugated.

9. A thermoelectric module (1) according to any preceding claim wherein the thermoelectric module (1) further comprises a mounting for securing the heat absorbing side to a surface of the wall (23) of a building.

10. A wall panel for a building comprising a thermoelectric module (1) according to any preceding claim.

## Patentansprüche

1. Ein thermoelektrisches Modul (1) für die Verwendung in einer Wand eines Gebäudes, umfassend:
Einen thermoelektrischen Generator (3) mit einer wärmeabsorbierenden Seite und einer wärmeableitenden Seite und der eine Vielzahl von thermoelektrischen Abschnitten (11) umfasst, die sich dazwischen erstrecken; und
ein Halteteil (5), um die thermoelektrischen Abschnitte (11) zu halten, die zwischen der wärmeabsorbierenden Seite und der wärmeableitenden Seite vorhanden sind,
wobei die thermoelektrischen Abschnitte (11) durch die Kanäle (13) verlaufen, die im Halteteil (5) bereitgestellt sind und die Höhe der thermoelektrischen Abschnitte (11) größer ist als die Höhe des Halteteils (5), so dass die Enden der thermoelektrischen Abschnitte (11) aus dem Halteteil (5) herausragen; und
**gekennzeichnet dadurch, dass** das thermoelektrische Modul (1) ferner ein Dichtungsmittel (14) umfasst, um die thermoelektrischen Abschnitte (11) an dem Spalt zwischen dem Halteteil (5) und den leitfähigen Verbindungen (7,9) abzudichten.

2. Ein thermoelektrisches Modul (1) nach Anspruch 1, wobei die wärmeabsorbierende Seite und die wärmeableitende Seite die leitfähigen Verbindungen (7,9) umfassen, die abwechselnd an den entgegengesetzten Enden der thermoelektrischen Abschnitte (11) vorhanden sind, um die Vielzahl der thermoelektrischen Abschnitte (11) in Reihe zu verbinden.

3. Ein thermoelektrisches Modul (1) nach Anspruch 2, wobei jede leitfähige Verbindung (9) an der wärmeableitenden Seite einen geformten Abschnitt (9b) umfasst, der sich aus einer Ebene, die von den leitfähigen Verbindungen (9) an der wärmeableitenden Seite definiert wird, nach außen ragt.

4. Ein thermoelektrisches Modul (1) nach einem der vorhergehenden Ansprüche, wobei das Halteteil (5) teilweise flexibel ist, den Kontakt zwischen der wärmeabsorbierenden Seite und einer Oberfläche der Wand (23) des Gebäudes aufrechtzuerhalten.

5. Ein thermoelektrisches Modul (1) nach einem der Ansprüche 2 bis 4, wobei die leitfähigen Verbindungen (7), die auf der wärmeabsorbierenden Seite bereitgestellt werden, als flache Streifen geformt sind.

6. Ein thermoelektrisches Modul (1) nach einem der Ansprüche 2 bis 5, wobei sich die Ränder jeder der Vielzahl von leitfähigen Verbindungen (7,9) über die Enden der jeweiligen thermoelektrischen Abschnitte (11) hinaus erstrecken, mit denen sie verbunden sind.

7. Ein thermoelektrisches Modul (1) nach einem der Ansprüche 2 bis 6, wobei die Vielzahl der leitfähigen Verbindungen (7,9), die auf der wärmeabsorbierenden Seite und/oder der wärmeableitenden Seite bereitgestellt werden, an der Außenseite des Moduls (1) exponiert sind.

8. Ein thermoelektrisches Modul (1) nach einem der Ansprüche 3 bis 7, wobei der geformte Abschnitt eine Faltenbalg-Form oder geriffelte Form aufweist.

9. Ein thermoelektrisches Modul (1) nach einem der vorhergehenden Ansprüche, wobei das thermoelektrische Modul (1) ferner ein Befestigungselement umfasst, um die wärmeabsorbierende Seite an einer Oberfläche der Wand (23) des Gebäudes zu befestigen.

10. Eine Wandplatte für ein Gebäude, die ein thermoelektrisches Modul (1) nach einem der vorhergehenden Ansprüche umfasst.

## Revendications

1. Module thermoélectrique (1) destiné à être utilisé dans un mur d'un bâtiment comprenant :
un générateur thermoélectrique (3) présentant un côté absorbant la chaleur et un côté dissipant la chaleur et comprenant une pluralité de pieds thermoélectriques (11) s'étendant entre ceux-ci ; et
un élément de support (5) destiné à supporter les pieds thermoélectriques (11), fourni entre le côté absorbant la chaleur et le côté dissipant la chaleur,
dans lequel les pieds thermoélectriques (11) passent à travers des canaux (13) fournis dans l'élément de support (5) et la hauteur des pieds thermoélectriques (11) est supérieure à la hauteur de l'élément de support (5) de manière à ce que les extrémités des pieds thermoélectriques (11) fassent saillie depuis l'élément de support (5) ; et
**caractérisé en ce que** le module thermoélectrique (1) comprend en outre un produit d'étanchéité (14) destiné à assurer l'étanchéité des pieds thermoélectriques (11) au niveau de l'espace entre l'élément de support (5) et les interconnexions conductrices (7,9).

2. Module thermoélectrique (1) selon la revendication 1, dans lequel le côté absorbant la chaleur et le côté dissipant la chaleur comprennent les interconnexions conductrices (7,9) fournies par ailleurs sur les extrémités opposées des pieds thermoélectriques (11) pour connecter la pluralité de pieds thermoélectriques (11) en série.

3. Module thermoélectrique (1) selon la revendication 2, dans lequel chaque interconnexion conductrice (9) sur le côté dissipant la chaleur comprend une section façonnée (9b) qui se projette vers l'extérieur à partir d'un plan défini par les interconnexions conductrices (9) sur le côté dissipant la chaleur.

4. Module thermoélectrique (1) selon l'une quelconque revendication précédente, dans lequel l'élément de support (5) est partiellement flexible pour maintenir le contact entre le côté absorbant la chaleur et une surface du mur (23) d'un immeuble.

5. Module thermoélectrique (1) selon l'une quelconque des revendications 2 à 4, dans lequel les interconnexions conductrices (7) fournies sur le côté absorbant la chaleur sont façonnées comme des bandes plates.

6. Module thermoélectrique (1) selon l'une quelconque des revendications 2 à 5, dans lequel les bords de chacune de la pluralité d'interconnexions conductrices (7,9) s'étendent au-delà des extrémités des pieds thermoélectriques respectifs (11) auxquels ils sont connectés.

7. Module thermoélectrique (1) selon l'une quelconque des revendications 2 à 6, dans lequel la pluralité d'interconnexions conductrices (7,9) fournies sur le côté absorbant la chaleur et/ou le côté dissipant la chaleur sont apparents sur l'extérieur du module (1).

8. Module thermoélectrique (1) selon l'une quelconque des revendications 3 à 7, dans lequel la section façonnée est en forme d'accordéon ou ondulée.

9. Module thermoélectrique (1) selon l'une quelconque revendication précédente, dans lequel le module thermoélectrique (1) comprend en outre un support de fixation destiné à fixer solidement le côté absorbant la chaleur à la surface du mur (23) d'un immeuble.

10. Panneau mural destiné à un bâtiment comprenant un module thermoélectrique (1) selon l'une quelconque revendication précédente.
